# EUROPEAN PATENT SPECIFICATION

(11) **EP 3 934 042 B1**
(45) Date of publication and mention of the grant of the patent: **24.05.2023**
(21) Application number: 21773278.3
(22) Date of filing: 08.03.2021
(51) Int. Cl.: H02H 9/04, H01L 27/02

(54) **ELECTROSTATIC PROTECTION CIRCUIT AND FULL-CHIP ELECTROSTATIC PROTECTION CIRCUIT**
ELEKTROSTATISCHE SCHUTZSCHALTUNG UND ELEKTROSTATISCHE VOLLCHIP-SCHUTZSCHALTUNG
CIRCUIT DE PROTECTION ÉLECTROSTATIQUE ET CIRCUIT DE PROTECTION ÉLECTROSTATIQUE ENTIÈREMENT À PUCE

(30) Priority: 26.03.2020 CN 202010224007
(43) Date of publication of application: 05.01.2022
(73) Proprietor: Changxin Memory Technologies, Inc., Hefei, Anhui 230000 (CN)
(72) Inventor: XU, QiAn, Hefei, Anhui 230000 (CN)
(74) Representative: Lavoix
(86) International application number: PCT/CN2021/079552
(87) International publication number: WO 2021/190287

(56) References cited:
- CN-A- 102 208 408
- CN-A- 104 283 198
- CN-A- 105 470 938
- CN-U- 210 156 919
- US-A1- 2007 171 587
- US-B2- 8 969 914
- KER MING-DOU ET AL: "On the Design of Power-Rail ESD Clamp Circuits With Gate Leakage Consideration in Nanoscale CMOS Technology", IEEE TRANSACTIONS ON DEVICE AND MATERIALS RELIABILITY, IEEE SERVICE CENTER, PISCATAWAY, NJ, US, vol. 14, no. 1, 1 March 2014 (2014-03-01), pages 536-544, XP011542101, ISSN: 1530-4388, DOI: 10.1109/TDMR.2013.2280044 [retrieved on 2014-03-04]

## Description

### TECHNICAL FIELD

The present application relates to the technical field of integrated circuits, and in particular to an electrostatic protection circuit and a full-chip electrostatic protection circuit.

### BACKGROUND OF THE PRESENT INVENTION

Nowadays, semiconductor manufacturing processes are getting more advanced, semiconductor devices are getting smaller, the junction depth is getting lower, and the oxide layer is getting thinner. The reliability of semiconductor integrated circuits is facing more and more challenges. Especially, the electrostatic protection is becoming more important. According to statistics, more than about 30% of the failures of semiconductor products are caused by electrostatic damage. In order to better protect the integrated circuits from electrostatic damage, it is necessary to provide an electrostatic protection circuit to protect the integrated circuits.

The RC time constant of the existing electrostatic protection circuits is usually 0.1 µs to 1 µs. However, the existing electrostatic protection circuits need a large RC time constant in order to achieve better electrostatic protection effect. As a result, the electrostatic protection circuits have a large area and will occupy a large design space.

Other prior art is disclosed in KER MING-DOU ET AL: "On the Design of Power-Rail ESD Clamp Circuits With Gate Leakage Consideration in Nanoscale CMOS Technology" IEEE TRANSACTIONS ON DEVICE AND MATERIALS RELIABILITY, IEEE SERVICE CENTER, PISCATAWAY, NJ, US, vol. 14, no. 1, published on 1 March 2014, pages 536-544. Other prior art is disclosed in US 8 969 914 B2, CN 105 470 938 A, and CN 102 208 408 A.

### SUMMARY OF THE PRESENT INVENTION

In a first aspect of the present application, an electrostatic protection circuit is provided, comprising:
a detection module, having a first terminal connected to a first voltage and a second terminal connected to a second voltage, configured to detect the type of the first voltage and output a detection result through a third terminal of the detection module;
a discharge module, having a first terminal connected to the first voltage and a second terminal connected to the second voltage; and
a control module, having a first terminal connected to the first voltage, a second terminal connected to the second voltage, a third terminal connected to the third terminal of the detection module, and a fourth terminal connected to the third end of the discharge module, configured to control the discharge module to be turned on or be turned off based on the detection result of the detection module.

The control module (12) comprises:
a first inverter (121), having a first terminal used as the third terminal of the control module (12) and a second terminal connected to the second voltage (VSS);
a second inverter (122), having a first terminal connected to a fourth terminal of the first inverter (121), a second terminal connected to the second voltage (VSS), and a third terminal connected to the first voltage (VDD);
a first PMOS transistor (MP1), having a gate connected to a fourth terminal of the second inverter (122), a source connected to the first voltage (VDD) and used, together with the third terminal of the second inverter (122), as the first terminal of the control module (12), and a drain connected to a third terminal of the first inverter (121);
and a first NMOS transistor (MN1) a gate of the first NMOS transistor is connected to the fourth terminal of the second inverter (122), a drain of the first NMOS transistor (MN1) is connected to the fourth terminal of the first inverter (121), and a source of the first NMOS transistor (MN1) is connected to the second voltage (VSS); wherein, the first PMOS transistor (MP1), the first NMOS transistor (MN1) and the second inverter (122) form a positive feedback loop.

The electrostatic protection circuit further comprises a pull-down resistor (R2), a first terminal of the pull-down resistor (R2) and the fourth terminal of the second inverter (122) are used as the fourth terminal of the control module (12), a second terminal of the pull-down resistor (R2) is connected to the second voltage (VSS), and the second terminal of the pull-down resistor (R2), the second terminal of the first inverter (121) and the second terminal of the second inverter (122) together form the second terminal of the control module (12).

This electrostatic protection circuit has a small RC time constant on the premise of achieving the required electrostatic protection effect, and the electrostatic protection circuit has a small area and will not occupy a large design space.

In a second aspect of the present application, a full-chip electrostatic protection circuit is further provided, comprising:
the electrostatic protection circuit according to the first aspect of the present application;
a core circuit, having a first terminal connected to the first voltage and a second terminal connected to the second voltage;
a first diode, having an anode connected to a signal input terminal of the core circuit and a cathode connected to the first voltage;
a second diode, having an anode connected to the second voltage and a cathode connected to the signal input terminal of the core circuit;
a third diode, having an anode connected to a signal output terminal of the core circuit and a cathode connected to the first voltage; and
a fourth diode, having an anode connected to the second voltage and a cathode connected to the signal output terminal of the core circuit.

This full-chip electrostatic protection circuit can realize electrostatic protection in four pressure modes by combining the diodes with the electrostatic protection circuit, which effectively improves the electrostatic protection capability of the product. It better ensures that the electrostatic protection device will not be turned on during the power-on and normal operation. The normal operation of the circuit is ensured without affecting the normal functioning of the existing core circuit.

### BRIEF DESCRIPTION OF THE DRAWINGS

In order to better describe and illustrate the embodiments of the present application, reference may be made to one or more drawings. However, the additional details or examples used to describe the drawings should not be considered as any limitation to the concept of the present application or any one of the currently described embodiments or preferred implementations.
FIG. 1 is a circuit diagram of an electrostatic protection circuit according to an example, not falling within the scope of the invention;
FIG. 2a is a circuit diagram of an electrostatic protection circuit according to an embodiment;
FIG. 2b is a circuit diagram of an electrostatic protection circuit according to an example, not falling within the scope of the invention;
FIG. 3 is a circuit diagram of a full-chip electrostatic protection circuit according to an example, not falling within the scope of the invention; and
FIG. 4 is a circuit diagram of a full-chip electrostatic protection circuit according to another embodiment.

### DETAILED DESCRIPTION OF THE PRESENT INVENTION

In order to facilitate the understanding of the present application, the present application will be described more fully below with reference to the relevant drawings. Preferred embodiments of the present application are shown in the drawings. However, the present application may be implemented in many different forms and is not limited to the embodiments described herein. On the contrary, these embodiments are provided to make the disclosure of the present application more thorough and comprehensive.

It should be noted that, when an element is referred to as being "connected to" other elements, the element may be connected to the other elements directly or with intervening elements therebetween. The terms "installed", "one terminal", "the other terminal" and similar expressions used herein are for illustrative purposes only.

Unless otherwise defined, all technical and scientific terms used herein have the same meaning as commonly understood by a person of ordinary skill in the art to which the present application belongs. Here, terms used in the description of the present application are merely intended to describe specific embodiments, rather than limiting the present application. As used herein, the term "and/or" includes any or all of one or more associated items listed here or combinations thereof.

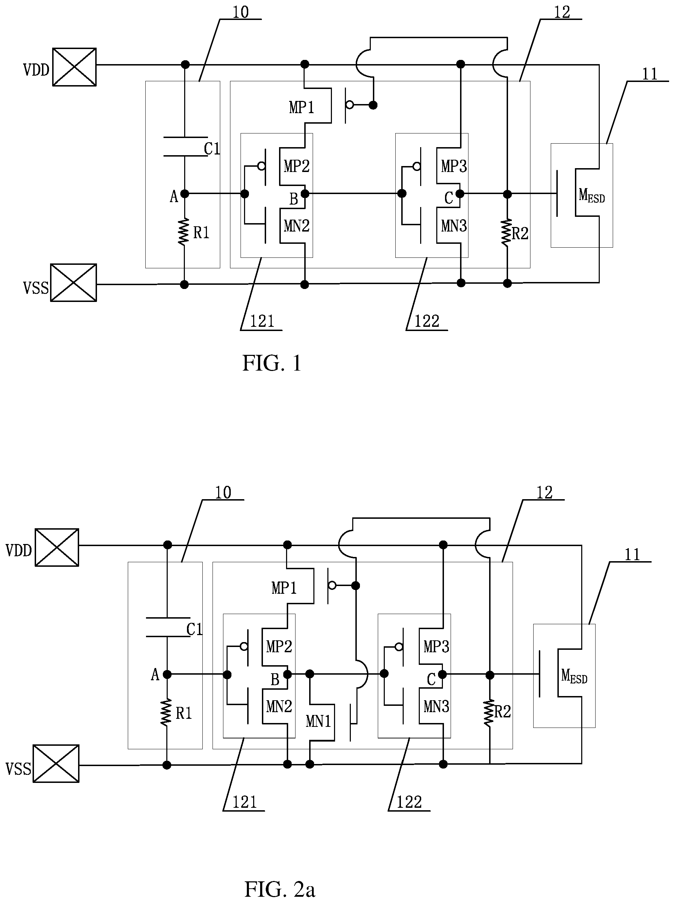

In an example, as shown in FIG. 1, an electrostatic protection circuit of the present application comprises: a detection module 10, having a first terminal connected to a first voltage VDD and a second terminal connected to a second voltage VSS, configured to detect the type of the first voltage VDD and output the detection result through a third terminal (terminal A in FIG. 1) of the detection module 10; a discharge module 11, having a first terminal connected to the first voltage VDD and a second terminal connected to the second voltage VSS; and a control module 12, having a first terminal connected to the first voltage VDD, a second terminal connected to the second voltage VSS, a third terminal connected to the third terminal of the detection module 10, and a fourth terminal (terminal C in FIG. 1) connected to a third terminal of the discharge module 11, configured to control the discharge module 11 to be turned on or off based on the detection result of the detection module 10.

This electrostatic protection circuit has a small RC time constant on the premise of achieving the required electrostatic protection effect, and the electrostatic protection circuit has a small area and will not occupy a large design space.

In an example, the detection module 10 comprises: a capacitor C1, having a first terminal connected, as the first terminal of the detection module 10, to the first voltage VDD and a second terminal used as the third terminal of the detection module 10; and a resistor R1, having a first terminal connected to the second terminal of the capacitor C1 and a second terminal used as the second terminal of the detection module 10.

Specifically, the capacitor C1 may comprise, but is not limited to, a metal-dielectric-metal capacitor or an MOS capacitor; and the resistor R1 may comprise, but is not limited to, a polyresistor or a doped region resistor.

In an example, the discharge module 11 may comprise a discharge transistor MESD. The discharge transistor MESD may be an NMOS transistor. A drain of the discharge transistor MESD is connected, as the first terminal of the discharge module 11, to the first voltage VDD; a source of the discharge transistor MESD is connected, as the second terminal of the discharge module 11, to the second voltage VSS; and a gate of the discharge transistor MESD is connected, as the third terminal of the discharge module 11, to the fourth terminal of the control module 12.

In an example, the control module 12 comprises a positive feedback loop. The positive feedback loop comprises an inverter and a PMOS transistor.

In an example, the control module 12 comprises: a first inverter 121, having a first terminal connected, as the third terminal of the control module 12, to the third terminal of the detection module 10, and a second terminal connected to the second voltage VSS; a second inverter 122, having a first terminal connected to a fourth terminal of the first inverter 121, a second terminal connected to the second voltage VSS, and a third terminal connected to the first voltage VDD; a first PMOS transistor MP1, having a gate connected to a fourth terminal of the second inverter 122, a source connected to the first voltage VDD, and a drain connected to the third terminal of the first inverter 121; wherein, the first PMOS transistor MP1 and the second inverter 122 form the positive feedback loop.

In an example, the first inverter 121 comprises a second PMOS transistor MP2 and a second NMOS transistor MN2; the gate of the second PMOS transistor MP2 and the gate of the second NMOS transistor MN2 are connected together as the third terminal of the control module 12, the source of the second PMOS transistor MP2 is connected to the drain of the first PMOS transistor MP1, and the drain of the second PMOS transistor MP2 and the drain of the second NMOS transistor MN2 are connected together as the fourth terminal (terminal B in FIG. 1) of the first inverter 121; the source of the second NMOS transistor MN2 is used as the second terminal of the first inverter 121.

In an example, the second inverter 122 comprises a third PMOS transistor MP3 and a third NMOS transistor MN3; the gate of the third PMOS transistor MP3 and the gate of the third NMOS transistor MN3 are connected together as the first terminal of the second inverter 122, the source of the third PMOS transistor MP3 is used as the third terminal of the second inverter 122, the source of the third PMOS transistor MP3 and the source of the first PMOS transistor MP1 are connected, as the first terminal of the control module 12, to the first voltage VDD, the drain of the third PMOS transistor MP3 and the drain of the third NMOS transistor MN3 are connected together as the fourth terminal of the second inverter 122, and the source of the third NMOS transistor MN3 is used as the second terminal of the second inverter 122.

In an example, the electrostatic protection circuit further comprises a pull-down resistor R2, a first terminal of the pull-down resistor R2 and the fourth terminal of the second inverter 122 are connected together as the fourth terminal of the control module 12, a second terminal of the pull-down resistor R2 is connected to the second voltage VSS, and the second terminal of the pull-down resistor R2, the second terminal of the first inverter 121 and the second terminal of the second inverter 122 together form the second terminal of the control module 12.

Specifically, the resistance R2 may comprise, but is not limited to, a polyresistor or a doped region resistor.

The working principle of the electrostatic protection circuit shown in FIG. 1 will be described below. When electrostatic current occurs, the third terminal (terminal A in FIG. 1) of the detection module 10 is coupled to a high level through the capacitor C1 and the second NMOS transistor MN2 is turned on, and after the electrostatic current flows through the second NMOS transistor MN2, the fourth terminal (terminal B in FIG. 1) of the first inverter 121 is at a low level, the third PMOS transistor MP3 is turned on, the voltage at the fourth terminal (terminal C in FIG. 1) of the control module 12 increases, and the discharge transistor MESD is turned on to discharge the electrostatic current; the increase of the voltage at the fourth terminal of the control module 12 will weaken the conduction of the first PMOS transistor, which in turn further decreases the voltage at the fourth terminal of the first inverter 121 and further increases the gate voltage of the discharge transistor MESD. Such a positive feedback method can accelerate the electrostatic discharge. After a certain period of time, when the voltage at the third terminal of the detection module 10 becomes low due to the discharge by the resistor R1, the second NMOS transistor MN2 is turned off and the second PMOS transistor MP2 is turned on. However, because the fourth terminal of the control module 12 is still at a high level, the first PMOS transistor MP1 is turned off and the third NMOS transistor MN3 is turned on. Therefore, the feedback through the first PMOS transistor MP1 and the third NMOS transistor MN3 can ensure that the fourth terminal of the first inverter 121 is still at a low level, so as to ensure that the fourth terminal of the control module 12 remains at a high level. In this way, the electrostatic discharge time becomes longer, thereby ensuring the conduction speed of the discharge transistor MESD and the electrostatic discharge capacity. Thus, the RC time constant of the electrostatic protection circuit can be reduced. The reduced RC time constant can in turn lead to the reduced size of the electrostatic protection circuit, so that the design space occupied by the electrostatic protection circuit becomes smaller.

According to the invention, the positive feedback loop comprises an inverter, a first PMOS transistor, and a first NMOS transistor. Specifically, as shown in FIG. 2a, compared with the electrostatic protection circuit in FIG. 1, the electrostatic protection circuit in this example further comprises a first NMOS transistor MN1 on the basis of the electrostatic protection circuit in FIG. 1. The gate of the first NMOS transistor MN1 is connected to the fourth terminal of the second inverter 122. Specifically, the gate of the first NMOS transistor MN1 is connected to the drain of the third PMOS transistor MP3 and the drain of the third NMOS transistor MN3, the drain of the first NMOS transistor MN1 is connected to the fourth terminal of the first inverter 121, the source of the first NMOS transistor MN1 is connected to the second voltage VSS, and the source of the first NMOS transistor MN1, the source of the second NMOS transistor MN2 and the source of the third NMOS transistor MN3 are used together as the second terminal of the control module 12. The first PMOS transistor MP1, the first NMOS transistor MN1 and the second inverter 122 form a positive feedback loop.

The working principle of the electrostatic protection circuit shown in FIG. 2a will be described below. When electrostatic current occurs, the third terminal (terminal A in FIG. 2a) of the detection module 10 is coupled to a high level through the capacitor C1 and the second NMOS transistor MN2 is turned on, and after the electrostatic current flows through the second NMOS transistor MN2, the fourth terminal (terminal B in FIG. 2a) of the first inverter 121 is at a low level, the third PMOS transistor MP3 is turned on, the voltage at the fourth terminal (terminal C in FIG. 2a) of the control module 12 is at a high level, and the discharge transistor MESD is turned on to discharge the electrostatic current; the increase of the voltage at the fourth terminal of the control module 12 will weaken the conduction of the first PMOS transistor and meanwhile the first NMOS transistor MN1 is turned on, which can further accelerate the pull-down of the potential at the fourth terminal of the first inverter 121, so that the voltage at the fourth terminal of the first inverter 121 decreases faster and the gate voltage of the discharge transistor MESD is further increased. Such a positive feedback method can accelerate the electrostatic discharge. After a certain period of time, when the voltage at the third terminal of the detection module 10 becomes low due to the discharge by the resistor R1, the second NMOS transistor MN2 is turned off and the second PMOS transistor MP2 is turned on. However, because the fourth terminal of the control module 12 is still at a high level, the first PMOS transistor MP1 is turned off, the first NMOS transistor MN1 is turned on, and the first NMOS transistor MN1 is turned on to pull the level of the fourth terminal of the first inverter 121 down, so that the level of the fourth terminal of the first inverter 121 is further decreased. Therefore, the feedback through the first PMOS transistor MP1, the third NMOS transistor MN3 and the first NMOS transistor MN1 can ensure that the fourth terminal of the first inverter 121 is still at a low level, so as to ensure that the fourth terminal of the control module 12 remains at a high level. Thus, the electrostatic discharge time becomes longer than that of the electrostatic protection circuit shown in FIG. 1. Further, by setting an appropriate size for MN3, for example increasing the channel width of the first NMOS transistor MN1, the fourth terminal of the first inverter 121 can always maintain at a low level during the electrostatic discharge process until the electrostatic charges are all discharged. Therefore, the conduction speed of the discharge transistor MESD and the electrostatic discharge capacity are ensured. Thus, the RC time constant of the electrostatic protection circuit can be reduced. The reduced RC time constant can in turn lead to the reduced size of the electrostatic protection circuit, so that the design space occupied by the electrostatic protection circuit becomes smaller.

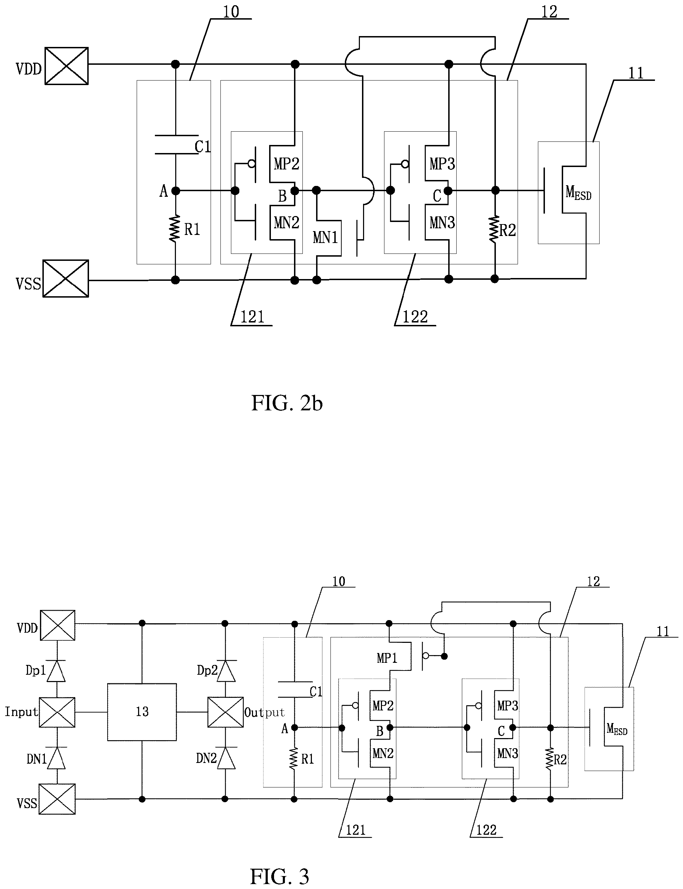

Of course, in other examples, the positive feedback loop comprises an inverter and an NMOS transistor. Specifically, as shown in FIG. 2b, the electrostatic protection circuit in this example may not comprise the first PMOS transistor MP1, when compared with that in FIG. 2a. The other circuit structures in this example are the same as the corresponding structures in FIG. 2a, and will not be repeated here. In this example, the first NMOS transistor MN1 and the second inverter 122 form a positive feedback loop.

The working principle of the electrostatic protection circuit shown in FIG. 2b will be described below. When electrostatic current occurs, the third terminal (terminal A in FIG. 2b) of the detection module 10 is coupled to a high level through the capacitor C1 and the second NMOS transistor MN2 is turned on, and after the electrostatic current flows through the second NMOS transistor MN2, the fourth terminal (terminal B in FIG. 2b) of the first inverter 121 is at a low level, the third PMOS transistor MP3 is turned on, the voltage at the fourth terminal (terminal C in FIG. 2b) of the control module 12 is at a high level, and the discharge transistor MESD is turned on to discharge the electrostatic current; the increase of the voltage at the fourth terminal of the control module 12 will cause the first NMOS MN1 transistor to be turned on, which can accelerate the pull-down of the potential at the fourth terminal of the first inverter 121, so that the voltage at the fourth terminal of the first inverter 121 decreases faster and the gate voltage of the discharge transistor MESD is further increased. Such a positive feedback method can accelerate the electrostatic discharge. After a certain period of time, when the voltage at the third terminal of the detection module 10 becomes low due to the discharge by the resistor R1, the second NMOS transistor MN2 is turned off and the second PMOS transistor MP2 is turned on. However, because the fourth terminal of the control module 12 is still at a high level, the first NMOS transistor MN1 is turned on. The turning-on of the first NMOS transistorMN1 can pull the level of the fourth terminal of the first inverter 121 down, so that the level of the fourth terminal of the first inverter 121 further decreases. Therefore, the feedback through the third NMOS transistor MN3 and the first NMOS transistor MN1 can ensure that the fourth terminal of the first inverter 121 is still at a low level, so as to ensure that the fourth terminal of the control module 12 remains at a high level, thereby ensuring the conduction speed of the discharge transistor MESD and the electrostatic discharge capacity. Thus, the RC time constant of the electrostatic protection circuit can be reduced. The reduced RC time constant can in turn lead to the reduced size of the electrostatic protection circuit, so that the design space occupied by the electrostatic protection circuit becomes smaller.

Referring to FIG. 3, the present application further provides a full-chip electrostatic protection circuit, comprising: the electrostatic protection circuit as shown in FIG. 1; a core circuit 13, having a first terminal connected to the first voltage VDD and a second terminal connected to the second voltage VSS, wherein the core circuit 13 may be any existing circuit that needs electrostatic protection and its specific structure will not be repeated here; a first diode Dp1, having an anode connected to a signal input terminal (terminal Input in FIG. 3) of the core circuit 13 and a cathode connected to the first voltage VDD; a second diode DN1, having an anode connected to the second voltage VSS and a cathode connected to the signal input terminal of the core circuit 13; a third diode Dp2, having an anode connected to a signal output terminal (terminal Output in FIG. 3) of the core circuit 13 and a cathode connected to the first voltage VDD; and a fourth diode DN2, having an anode connected to the second voltage VSS and a cathode connected to the signal output terminal of the core circuit 13.

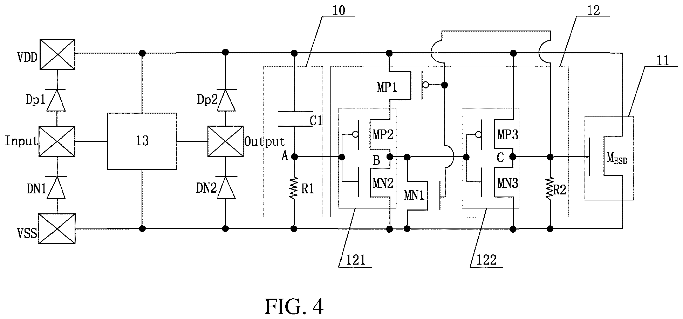

Referring to FIG. 4, the present application further provides a full-chip electrostatic protection circuit, comprising: the electrostatic protection circuit as shown in FIG. 2a; a core circuit 13, having a first terminal connected to the first voltage VDD and a second terminal connected to the second voltage VSS, wherein the core circuit 13 may be any existing circuit that needs electrostatic protection and its specific structure will not be repeated here; a first diode Dp1, having an anode connected to a signal input terminal (terminal Input in FIG. 3) of the core circuit 13 and a cathode connected to the first voltage VDD; a second diode DN1, having an anode connected to the second voltage VSS and a cathode connected to the signal input terminal of the core circuit 13; a third diode Dp2, having an anode connected to a signal output terminal (terminal Output in FIG. 3) of the core circuit 13 and a cathode connected to the first voltage VDD; and a fourth diode DN2, having an anode connected to the second voltage VSS and a cathode connected to the signal output terminal of the core circuit 13.

Of course, in other embodiments, the present application further provides a full-chip electrostatic protection circuit. The full-chip electrostatic protection circuit in this embodiment is substantially the same as the full-chip electrostatic protection circuit shown in FIG. 4, with the only difference that the electrostatic protection circuit in the full-chip electrostatic protection circuit shown in FIG. 4 is the electrostatic protection circuit shown in FIG. 2a, and the electrostatic protection circuit in the full-chip protection circuit in this embodiment is the electrostatic protection circuit shown in FIG. 2b.

The full-chip electrostatic protection circuit shown in FIG. 3 and FIG. 4 provides electrostatic protection in four pressure modes: PD mode, ND mode, NS mode and PS mode. In the PD mode, the full-chip electrostatic protection circuit discharges electrostatic current through the first diode Dp1 or the third diode Dp2; in the ND mode, the full-chip electrostatic protection circuit discharges electrostatic current through the second diode DN1, the fourth diode DN2, and the discharge transistor MESD; in the NS mode, the full-chip electrostatic protection circuit discharges the electrostatic current through the second diode DN1 and the fourth diode DN2; and in the PS mode, the full-chip electrostatic protection circuit discharges the electrostatic current through the first diode Dp1 or the third diode Dp2 and the discharge transistor MESD.

The embodiments described above merely represent certain implementations of the present application. Although those embodiments are described in more specific details, it is not to be construed as any limitation to the scope of the present application. The scope of the invention is defined by the appended claims.

## Claims

1. An electrostatic protection circuit, **characterized by** comprising:
a detection module (10), having a first terminal connected to a first voltage (VDD) and a second terminal connected to a second voltage (VSS), configured to detect the type of the first voltage (VDD) and output a detection result through a third terminal of the detection module (10);
a discharge module (11), having a first terminal connected to the first voltage (VDD) and a second terminal connected to the second voltage (VSS); and
a control module (12), having a first terminal connected to the first voltage (VDD), a second terminal connected to the second voltage (VSS), a third terminal connected to the third terminal of the detection module (10), and a fourth terminal connected to the third end of the discharge module (11), configured to control the discharge module (11) to be turned on or be turned off based on the detection result of the detection module (10);
wherein the control module (12) comprises:
a first inverter (121), having a first terminal used as the third terminal of the control module (12) and a second terminal connected to the second voltage (VSS);
a second inverter (122), having a first terminal connected to a fourth terminal of the first inverter (121), a second terminal connected to the second voltage (VSS), and a third terminal connected to the first voltage (VDD);
a first PMOS transistor (MP1), having a gate connected to a fourth terminal of the second inverter (122), a source connected to the first voltage (VDD) and used, together with the third terminal of the second inverter (122), as the first terminal of the control module (12), and a drain connected to a third terminal of the first inverter (121);
and a first NMOS transistor (MN1) ,wherein a gate of the first NMOS transistor is connected to the fourth terminal of the second inverter (122), a drain of the first NMOS transistor (MN1) is connected to the fourth terminal of the first inverter (121), and a source of the first NMOS transistor (MN1) is connected to the second voltage (VSS); wherein, the first PMOS transistor (MP1), the first NMOS transistor (MN1) and the second inverter (122) form a positive feedback loop;
wherein the electrostatic protection circuit further comprises a pull-down resistor (R2), a first terminal of the pull-down resistor (R2) and the fourth terminal of the second inverter (122) are used as the fourth terminal of the control module (12), a second terminal of the pull-down resistor (R2) is connected to the second voltage (VSS), and the second terminal of the pull-down resistor (R2), the second terminal of the first inverter (121) and the second terminal of the second inverter (122) together form the second terminal of the control module (12).

2. The electrostatic protection circuit according to claim 1, wherein the detection module (10) comprises:
a capacitor (C1), having a first terminal used as the first terminal of the detection module (10) and a second terminal used as the third terminal of the detection module (10); and
a resistor (R1), having a first terminal connected to the second terminal of the capacitor (C1) and a second terminal used as the second terminal of the detection module (10).

3. The electrostatic protection circuit according to claim 1, wherein the capacitor (C1) comprises a metal-dielectric-metal capacitor or an MOS capacitor, and the resistor (R1) comprises a polyresistor or a doped region resistor.

4. The electrostatic protection circuit according to claim 1, wherein the discharge module (11) comprises a discharge transistor (MESD).

5. The electrostatic protection circuit according to claim 4, wherein the discharge transistor (MESD) comprises an NMOS transistor, a drain of the discharge transistor (MESD) is used as the first terminal of the discharge module (11), and a source of the discharge transistor (MESD) is used as the second terminal of the discharge module (11), and a gate of the discharge transistor (MESD) is used as the third terminal of the discharge module (11).

6. The electrostatic protection circuit according to claim 1, wherein,
the first inverter (121) comprises a second PMOS transistor (MP2) and a second NMOS transistor (MN2); a gate of the second PMOS transistor (MP2) and a gate of the second NMOS transistor (MN2) are connected together as the third terminal of the control module (12), a source of the second PMOS transistor (MP2) is connected to the drain of the first PMOS transistor (MP1), and a drain of the second PMOS transistor (MP2) and a drain of the second NMOS transistor (MN2) are connected together as the fourth terminal of the first inverter (121); a source of the second NMOS transistor (MN2) is used as the second terminal of the first inverter (121); and
the second inverter (122) comprises a third PMOS transistor (MP3) and a third NMOS transistor (MN3); a gate of the third PMOS transistor (MP3) and a gate of the third NMOS transistor (MN3) are connected together as the first terminal of the second inverter (122), a source of the third PMOS transistor (MP3) is used as the third terminal of the second inverter (122), the source of the third PMOS transistor (MP3) and the source of the first PMOS transistor (MP1) are used together as the first terminal of the control module (12), a drain of the third PMOS transistor (MP3) and a drain of the third NMOS transistor (MN3) are connected together as the fourth terminal of the second inverter (122), and a source of the third NMOS transistor (MN3) is used as the second terminal of the second inverter (122).

7. A full-chip electrostatic protection circuit, **characterized by** comprising:
the electrostatic protection circuit according to any one of claims 1 to 6;
a core circuit (13), having a first terminal connected to the first voltage (VDD) and a second terminal connected to the second voltage (VSS);
a first diode (Dp1), having an anode connected to a signal input terminal of the core circuit (13) and a cathode connected to the first voltage (VDD);
a second diode (DN1), having an anode connected to the second voltage (VSS) and a cathode connected to the signal input terminal of the core circuit (13);
a third diode (Dp2), having an anode connected to a signal output terminal of the core circuit (13) and a cathode connected to the first voltage (VDD); and
a fourth diode (DN2), having an anode connected to the second voltage (VSS) and a cathode connected to the signal output terminal of the core circuit (13).

## Patentansprüche

1. Elektrostatische Schutzschaltung, **dadurch gekennzeichnet, dass** sie Folgendes umfasst:
ein Erfassungsmodul (10), das einen ersten Anschluss, der mit einer ersten Spannung (VDD) verbunden ist, und einen zweiten Anschluss, der mit einer zweiten Spannung (VSS) verbunden ist, aufweist und konfiguriert ist, um den Typ der ersten Spannung (VDD) zu erfassen und ein Erfassungsergebnis über einen dritten Anschluss des Erfassungsmoduls (10) auszugeben;
ein Entladungsmodul (11), das einen ersten Anschluss, der mit der ersten Spannung (VDD) verbunden ist, und einen zweiten Anschluss, der mit der zweiten Spannung (VSS) verbunden ist, aufweist; und
ein Steuermodul (12), das einen ersten Anschluss aufweist, der mit der ersten Spannung (VDD) verbunden ist, einen zweiten Anschluss, der mit der zweiten Spannung (VSS) verbunden ist, einen dritten Anschluss, der mit dem dritten Anschluss des Erfassungsmoduls (10) verbunden ist, und einen vierten Anschluss, der mit dem dritten Ende des Entladungsmoduls (11) verbunden ist, aufweist, das konfiguriert ist, um das Entladungsmodul (11) zu steuern, um basierend auf dem Erfassungsresultat des Erfassungsmoduls (10) ein- oder ausgeschaltet zu werden;
wobei das Steuermodul (12) Folgendes umfasst:
einen ersten Wechselrichter (121), der einen ersten Anschluss, der als dritter Anschluss des Steuermoduls (12) verwendet wird, und einen zweiten Anschluss, der mit der zweiten Spannung (VSS) verbunden ist, aufweist;
einen zweiten Wechselrichter (122), der einen ersten Anschluss, der mit einem vierten Anschluss des ersten Wechselrichters (121) verbunden ist, einen zweiten Anschluss, der mit der zweiten Spannung (VSS) verbunden ist, und einen dritten Anschluss, der mit der ersten Spannung (VDD) verbunden ist aufweist;
einen ersten PMOS-Transistor (MP1), der ein Gate, das mit einem vierten Anschluss des zweiten Wechselrichters (122) verbunden ist, eine Source, die mit der ersten Spannung (VDD) verbunden ist und zusammen mit dem dritten Anschluss des zweiten Wechselrichters (122) als erster Anschluss des Steuermoduls (12) verwendet wird, und einen Drain, der mit einem dritten Anschluss des ersten Wechselrichters (121) verbunden ist, aufweist;
einen ersten NMOS-Transistor (MN1), wobei ein Gate des ersten NMOS-Transistors mit dem vierten Anschluss des zweiten Wechselrichters (122) verbunden ist, ein Drain des ersten NMOS-Transistors (MN1) mit dem vierten Anschluss des ersten Wechselrichters (121) verbunden ist, und eine Source des ersten NMOS-Transistors (MN1) mit der zweiten Spannung (VSS) verbunden ist; wobei der erste PMOS-Transistor (MP1), der erste NMOS-Transistor (MN1) und der zweite Wechselrichter (122) eine positive Rückkopplungsschleife bilden;
wobei die elektrostatische Schutzschaltung ferner einen Pulldown-Widerstand (R2) umfasst, ein erster Anschluss des Pulldown-Widerstands (R2) und der vierte Anschluss des zweiten Wechselrichters (122) als vierter Anschluss des Steuermoduls (12) verwendet werden, ein zweiter Anschluss des Pulldown-Widerstands (R2) mit der zweiten Spannung (VSS) verbunden ist, und der zweite Anschluss des Pulldown-Widerstands (R2), der zweite Anschluss des ersten Wechselrichters (121) und der zweite Anschluss des zweiten Wechselrichters (122) zusammen den zweiten Anschluss des Steuermoduls (12) bilden.

2. Elektrostatische Schutzschaltung nach Anspruch 1, wobei das Erfassungsmodul (10) Folgendes umfasst:
einen Kondensator (C1), der einen ersten Anschluss, der als erster Anschluss des Detektionsmoduls (10) verwendet wird, und einen zweiten Anschluss, der als dritter Anschluss des Detektionsmoduls (10) verwendet wird, aufweist; und
einen Widerstand (R1), der einen ersten Anschluss, der mit dem zweiten Anschluss des Kondensators (C1) verbunden ist, und einen zweiten Anschluss, der als der zweite Anschluss des Erfassungsmoduls (10) verwendet wird, aufweist.

3. Elektrostatische Schutzschaltung nach Anspruch 1, wobei der Kondensator (C1) einen Metall-Dielektrikum-Metall-Kondensator oder einen MOS-Kondensator umfasst und der Widerstand (R1) einen Polyresistor oder einen Widerstand mit dotierter Region umfasst.

4. Elektrostatische Schutzschaltung nach Anspruch 1, wobei das Entladungsmodul (11) einen Entladungstransistor (MESD) umfasst.

5. Elektrostatische Schutzschaltung nach Anspruch 4, wobei der Entladetransistor (MESD) einen NMOS-Transistor umfasst, ein Drain des Entladetransistors (MESD) als erster Anschluss des Entlademoduls (11) verwendet wird, und eine Source des Entladetransistors (MESD) als zweiter Anschluss des Entlademoduls (11) verwendet wird, und ein Gate des Entladetransistors (MESD) als dritter Anschluss des Entlademoduls (11) verwendet wird.

6. Elektrostatische Schutzschaltung nach Anspruch 1, wobei
der erste Wechselrichter (121) einen zweiten PMOS-Transistor (MP2) und einen zweiten NMOS-Transistor (MN2) umfasst; ein Gate des zweiten PMOS-Transistors (MP2) und ein Gate des zweiten NMOS-Transistors (MN2) als dritter Anschluss des Steuermoduls (12) miteinander verbunden sind, eine Source des zweiten PMOS-Transistors (MP2) mit dem Drain des ersten PMOS-Transistors (MP1) verbunden ist, und ein Drain des zweiten PMOS-Transistors (MP2) und ein Drain des zweiten NMOS-Transistors (MN2) als vierter Anschluss des ersten Wechselrichters (121) miteinander verbunden sind; eine Source des zweiten NMOS-Transistors (MN2) als der zweite Anschluss des ersten Wechselrichters (121) verwendet wird; und
der zweite Wechselrichter (122) einen dritten PMOS-Transistor (MP3) und einen dritten NMOS-Transistor (MN3) umfasst; ein Gate des dritten PMOS-Transistors (MP3) und ein Gate des dritten NMOS-Transistors (MN3) miteinander als erster Anschluss des zweiten Wechselrichters (122) verbunden sind, eine Source des dritten PMOS-Transistors (MP3) als dritter Anschluss des zweiten Wechselrichters (122) verwendet wird, die Source des dritten PMOS-Transistors (MP3) und die Source des ersten PMOS-Transistors (MP1) zusammen als erster Anschluss des Steuermoduls (12) verwendet werden, ein Drain des dritten PMOS-Transistors (MP3) und ein Drain des dritten NMOS-Transistors (MN3) als vierter Anschluss des zweiten Wechselrichters (122) zusammengeschaltet sind, und ein Source des dritten NMOS-Transistors (MN3) als zweiter Anschluss des zweiten Wechselrichters (122) verwendet wird.

7. Elektrostatische Full-Chip-Schutzschaltung, **dadurch gekennzeichnet, dass** sie Folgendes umfasst: die elektrostatische Schutzschaltung nach einem der Ansprüche 1 bis 6
eine Kernschaltung (13), die einen ersten Anschluss, der mit der ersten Spannung (VDD) verbunden ist, und einen zweiten Anschluss, der mit der zweiten Spannung (VSS) verbunden ist, aufweist;
eine erste Diode (Dp1), die eine Anode, die mit einem Signaleingangsanschluss der Kernschaltung (13) verbunden ist, und eine Kathode, die mit der ersten Spannung (VDD) verbunden ist aufweist;
eine zweite Diode (DN1), die eine Anode, die mit der zweiten Spannung (VSS) verbunden ist, und eine Kathode, die mit dem Signaleingangsanschluss der Kernschaltung (13) verbunden ist aufweist;
eine dritte Diode (Dp2), die eine Anode, die mit einem Signalausgangsanschluss der Kernschaltung (13) verbunden ist, und eine Kathode, die mit der ersten Spannung (VDD) verbunden ist, aufweist; und
eine vierte Diode (DN2), die eine Anode, die mit der zweiten Spannung (VSS) verbunden ist, und eine Kathode, die mit dem Signalausgangsanschluss der Kernschaltung (13) verbunden ist, aufweist.

## Revendications

1. Circuit de protection électrostatique, **caractérisé en ce qu'**il comprend :
un module de détection (10), ayant une première borne connectée à une première tension (VDD) et une deuxième borne connectée à une deuxième tension (VSS), configuré pour détecter le type de la première tension (VDD) et rendre en sortie un résultat de détection par l'intermédiaire d'une troisième borne du module de détection (10) ;
un module de décharge (11), ayant une première borne connectée à la première tension (VDD) et une seconde borne connectée à la seconde tension (VSS) ; et
un module de commande (12), ayant une première borne connectée à la première tension (VDD), une deuxième borne connectée à la deuxième tension (VSS), une troisième borne connectée à la troisième borne du module de détection (10), et une quatrième borne connectée à la troisième extrémité du module de décharge (11), configuré pour commander le module de décharge (11) afin qu'il soit activé ou désactivé en fonction du résultat de la détection du module de détection (10) ;
dans lequel le module de commande (12) comprend :
un premier onduleur (121), ayant une première borne utilisée comme troisième borne du module de commande (12) et une deuxième borne connectée à la deuxième tension (VSS) ;
un deuxième onduleur (122), dont une première borne est connectée à une quatrième borne du premier onduleur (121), une deuxième borne est connectée à la deuxième tension (VSS) et une troisième borne est connectée à la première tension (VDD) ;
un premier transistor PMOS (MP1), ayant une grille connectée à une quatrième borne du deuxième onduleur (122), une source connectée à la première tension (VDD) et utilisée, avec la troisième borne du deuxième onduleur (122), comme première borne du module de commande (12), et un drain connecté à une troisième borne du premier onduleur (121) ;
un premier transistor NMOS (MN1), dans lequel une grille du premier transistor NMOS est connectée à la quatrième borne du deuxième onduleur (122), un drain du premier transistor NMOS (MN1) est connecté à la quatrième borne du premier onduleur (121), et une source du premier transistor NMOS (MN1) est connectée à la deuxième tension (VSS) ; dans lequel le premier transistor PMOS (MP1), le premier transistor NMOS (MN1) et le deuxième onduleur (122) forment une boucle de rétroaction positive ;
dans lequel le circuit de protection électrostatique comprend en outre une résistance de rappel vers le niveau bas (R2), une première borne de la résistance de rappel vers le niveau bas (R2) et la quatrième borne du deuxième onduleur (122) sont utilisées comme quatrième borne du module de commande (12), une deuxième borne de la résistance de rappel vers le niveau bas (R2) est connectée à la deuxième tension (VSS), et la deuxième borne de la résistance de rappel vers le niveau bas (R2), la deuxième borne du premier onduleur (121) et la deuxième borne du deuxième onduleur (122) forment ensemble la deuxième borne du module de commande (12).

2. Circuit de protection électrostatique selon la revendication 1, dans lequel le module de détection (10) comprend :
un condensateur (C1) ayant une première borne utilisée comme première borne du module de détection (10) et une deuxième borne utilisée comme troisième borne du module de détection (10) ; et
une résistance (R1) dont une première borne est reliée à la deuxième borne du condensateur (C1) et dont une deuxième borne est utilisée comme deuxième borne du module de détection (10).

3. Circuit de protection électrostatique selon la revendication 1, dans lequel le condensateur (C1) comprend un condensateur métal-diélectrique-métal ou un condensateur MOS, et la résistance (R1) comprend une polyrésistance ou une résistance à région dopée.

4. Circuit de protection électrostatique selon la revendication 1, dans lequel le module de décharge (11) comprend un transistor de décharge (MESD).

5. Circuit de protection électrostatique selon la revendication 4, dans lequel le transistor de décharge (MESD) comprend un transistor NMOS, un drain du transistor de décharge (MESD) est utilisé comme première borne du module de décharge (11), et une source du transistor de décharge (MESD) est utilisée comme deuxième borne du module de décharge (11), et une grille du transistor de décharge (MESD) est utilisée comme troisième borne du module de décharge (11).

6. Circuit de protection électrostatique selon la revendication 1, dans lequel :
le premier onduleur (121) comprend un deuxième transistor PMOS (MP2) et un deuxième transistor NMOS (MN2) ; une grille du deuxième transistor PMOS (MP2) et une grille du deuxième transistor NMOS (MN2) sont connectées ensemble en tant que troisième borne du module de commande (12), une source du deuxième transistor PMOS (MP2) est connectée au drain du premier transistor PMOS (MP1), et un drain du deuxième transistor PMOS (MP2) et un drain du deuxième transistor NMOS (MN2) sont connectés ensemble en tant que quatrième borne du premier onduleur (121) ; une source du deuxième transistor NMOS (MN2) est utilisée comme deuxième borne du premier onduleur (121) ; et
le deuxième onduleur (122) comprend un troisième transistor PMOS (MP3) et un troisième transistor NMOS (MN3) ; une grille du troisième transistor PMOS (MP3) et une grille du troisième transistor NMOS (MN3) sont connectées ensemble en tant que première borne du deuxième onduleur (122), une source du troisième transistor PMOS (MP3) est utilisée en tant que troisième borne du deuxième onduleur (122), la source du troisième transistor PMOS (MP3) et la source du premier transistor PMOS (MP1) sont utilisées ensemble en tant que première borne du module de commande (12), un drain du troisième transistor PMOS (MP3) et un drain du troisième transistor NMOS (MN3) sont connectés ensemble en tant que quatrième borne du deuxième onduleur (122), et une source du troisième transistor NMOS (MN3) est utilisée en tant que deuxième borne du deuxième onduleur (122).

7. Circuit de protection électrostatique pleine puce, **caractérisé en ce qu'**il comprend : le circuit de protection électrostatique selon l'une des revendications 1 à 6
un circuit central (13), ayant une première borne connectée à la première tension (VDD) et une seconde borne connectée à la seconde tension (VSS) ;
une première diode (Dp1), dont une anode est connectée à une borne d'entrée de signal du circuit central (13) et dont une cathode est connectée à la première tension (VDD) ;
une deuxième diode (DN1), dont une anode est connectée à la deuxième tension (VSS) et dont une cathode est connectée à la borne d'entrée du signal du circuit central (13) ;
une troisième diode (Dp2), dont une anode est connectée à une borne de sortie de signal du circuit central (13) et dont une cathode est connectée à la première tension (VDD) ; et
une quatrième diode (DN2), dont une anode est connectée à la deuxième tension (VSS) et une cathode est connectée à la borne de sortie du signal du circuit central (13).
